# EUROPEAN PATENT APPLICATION

(11) **EP 4 552 895 A1**
(43) Date of publication of application: **14.05.2025**
(21) Application number: 24164523.3
(22) Date of filing: 19.03.2024
(51) Int. Cl.: B60L 3/00, B60L 3/04, B60W 20/50, B60K 28/00, B60R 16/03

(54) **APPARATUS AND METHOD FOR PROTECTING BATTERY PACK**

(30) Priority: 07.11.2023 KR 20230152515
(71) Applicant: Samsung SDI Co., Ltd., Gyeonggi-do 17084 (KR)
(72) Inventor: LEE, Hwan, 16678 Suwon-si (KR); PARK, Seung Hyeok, 16678 Suwon-si (KR)
(74) Representative: Marks & Clerk LLP

(57) **Abstract**

The present disclosure relates to an apparatus and method for protecting a battery pack, and the technical object to be achieved is to provide an apparatus and method for protecting a battery pack in which, when a vehicle is started, the ignition of the vehicle may be stably turned off in response to a failure of a battery pack and a relay, and passengers and the vehicle may be protected from accidents. To this end, the apparatus of the present disclosure includes a battery module, a relay configured to allow an output of the battery module to be applied as a load of a vehicle or block the output of the battery module, an actuator operated by power supplied from a starter battery, and a processor configured to, when a start signal is input, monitor the battery module and detect a failure of the relay, and when the relay fails, control the actuator to operate to discharge the starter battery and block a start of the vehicle.

## Description

### BACKGROUND

### 1. Field

The present disclosure relates to an apparatus and method for protecting a battery pack in which a battery pack is protected in response to a failure of a relay of the battery pack.

### 2. Description of the Related Art

Unlike primary batteries that cannot be recharged, secondary batteries are batteries that are capable of being charged and discharged. Low-capacity secondary batteries are used in small portable electronic devices such as smartphones, feature or smart phones, laptop computers, digital cameras, camcorders and the like, and high-capacity secondary batteries are widely used as a power supply for driving motors of hybrid vehicles, electric vehicles, or the like, power storage batteries, and the like. Such a secondary battery includes an electrode assembly including a positive electrode and a negative electrode, a case for accommodating the same, and an electrode terminal connected to the electrode assembly.

Secondary batteries are charged by a charge current applied from the outside and output a discharge current to supply the discharge current to a load.

In such secondary batteries, as a relay connected to an output terminal is turned on or off, the input of a charge current and the output of a discharge current may change.

In order to control charging or discharging of secondary batteries, the secondary battery includes a battery management system (BMS) that controls the operation of a relay according to the magnitudes of a discharge current and a charge current.

In the case of electric vehicles or hybrid vehicles in which a secondary battery is installed, during driving, according to the input of a starter key, a BMS may check the status of a battery module, and when the battery module normally operates, the BMS may turn a relay on to supply power as required for driving the vehicle to the vehicle from the battery module.

When a failure of a battery module is detected, a BMS may block the output by turning a relay off, such that the output of the battery module is not supplied to the vehicle.

However, relays may fail due to their own internal defects or environmental defects.

When a failure of a relay occurs, since the output of a battery module cannot be controlled by a BMS, accidents may occur due to no control of the battery module, which may lead to safety issues for vehicle occupants.

In order to solve such a problem, vehicles include a plurality of relays designed in a dual structure, but when all the plurality of relays fail, the same safety problem occurs.

Accordingly, there is a need for a way to stably control the input and output of a battery module according to an operating state of a relay.

The above information disclosed in the background technology is only for enhancement of understanding of the background of the present invention, and this disclosure, and therefore it may contain information that does not constitute related art.

### SUMMARY

The present disclosure is directed to providing an apparatus and method for protecting a battery pack in which a battery pack is stably controlled in response to a failure of a relay provided in the battery pack.

However, the technical objects to be solved by the present disclosure are not limited to the above, and other objects that are not described herein will be clearly understood by those skilled in the art from the following disclosure.

According to an aspect of the present disclosure, there is provided an apparatus for protecting a battery pack, the apparatus including a battery module, a relay configured to allow an output of the battery module to be applied as a load of a vehicle or block the output of the battery module, an actuator operated by power supplied from a starter battery, and a processor configured to, when a start signal is input, monitor the battery module and detect a failure of the relay, and when the relay fails, control the actuator to operate to discharge the starter battery and block a start of the vehicle.

According to another aspect of the present disclosure there is provided a method of protecting a battery pack, the method comprising:
when a start signal is input, monitoring, by a processor, a battery module and detecting a failure of a relay;
when the relay fails, applying, by the processor, a control signal to an actuator of the vehicle;
operating the actuator using power supplied from a starter battery; and
discharging the starter battery and turning an ignition of the vehicle off.
At least some of the above and other features of the invention are set out in the claims.

### BRIEF DESCRIPTION OF THE DRAWINGS

The accompanying drawings illustrate embodiments of the present disclosure and, together with the following detailed description, serve to provide further understanding of the present disclosure. However, the present disclosure is not to be construed as being limited to the details shown in the drawings, in which:
FIGS. 1A and 1B are views illustrating, purely by way of example, an embodiment of a battery pack according to the present disclosure;
FIG. 2 is a view illustrating an embodiment in which a battery pack is installed in a vehicle body according to one embodiment of the present disclosure;
FIG. 3 briefly illustrates a configuration of a battery pack of an apparatus for protecting a battery pack and a vehicle;
FIG. 4 briefly illustrates a configuration of an apparatus for protecting a battery pack according to one embodiment of the present disclosure; and
FIG. 5 illustrates a method of protecting a battery pack according to one embodiment of the present disclosure.

### DETAILED DESCRIPTION

Hereinafter, embodiments of the present disclosure will be described in detail with reference to the accompanying drawings. Prior to the description, it should be understood that the terms used in the specification and the appended claims should not be construed as being limited to their usual or dictionary meanings, but interpreted based on the meanings and concepts corresponding to technical aspects of the present disclosure on the basis of the principle that the inventor can appropriately define the concepts of terms in order to describe his/her invention in the best way. Accordingly, since the embodiments described herein and configurations illustrated in the drawings are merely examples of some embodiments of the present disclosure and do not represent all of the technical ideas of the present disclosure, it should be understood that there may be various equivalents and modifications that can replace the embodiments and drawings at the time of filing the present application. Further, the terms "comprise and include" and/or "comprising and including" used in this specification should be interpreted as specifying the presence of described shapes, numbers, steps, operations, members, elements, and/or groups thereof and do not exclude the presence or addition of other shapes, numbers, steps, operations, members, elements, and/or groups thereof. Further, the use of "may" when describing embodiments of the present disclosure, is generally non limiting, and refers to "one or more embodiments of the present disclosure."

In addition, for a better understanding of the present disclosure, the accompanying drawings are not drawn to scale and sizes of some elements can be exaggerated. In addition, the same reference numbers may be assigned to the same components in different embodiments.

Stating that two objects of comparison are "the same" means that the two objects of comparison are "substantially the same." Therefore, substantially the same may include a deviation that is considered low in the art, for example, a deviation of 5% or less. Additionally, uniformity of a parameter in a certain area may mean uniformity from an average perspective.

Although the terms first, second, and the like are used to describe various components, these components are of course not limited by these terms. These terms are only used to distinguish one element from another element, and a first element may also be a second element unless otherwise stated.

Through the specification, each element may be singular or plural unless otherwise stated.

When it is said that an arbitrary element is disposed on "an upper portion (or a lower portion)" of an element or disposed "above (or below)" an element, this may not only mean that the arbitrary element is disposed in contact with an upper surface (or a lower surface) of the element, but also mean that another element may be interposed between the element and the arbitrary element disposed above (or below) the element.

Also, when it is said that a first element is "connected" or "coupled" to a second element, this may mean that the elements are directly connected or coupled to each other, but it should be understood that a third element may be "interposed" between the elements or the elements may be "connected" or "coupled" to each other via the third element, i.e. indirectly. Further, when a part is said to be "electrically coupled" to another part, this includes not only the case where the parts are directly connected but the case where the parts are connected via another element therebetween, i.e. indirectly.

Throughout the specification, "A and/or B" refers "A or B, or A and B" unless otherwise stated. That is, "and/or" includes all or any combination of a plurality of listed items. "C to D" refers to C or more and D or less unless otherwise stated.

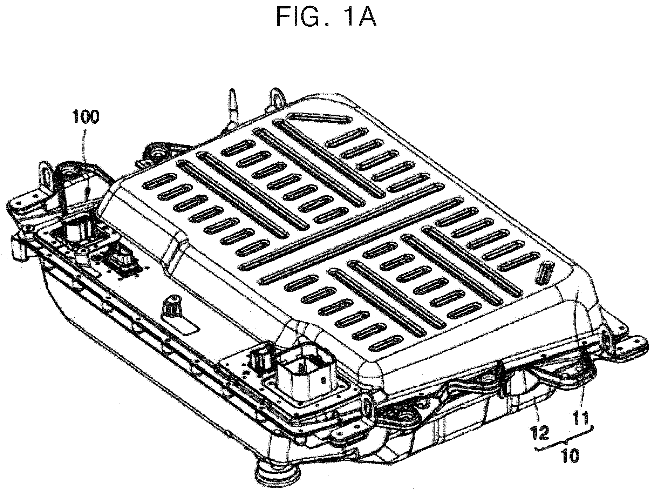

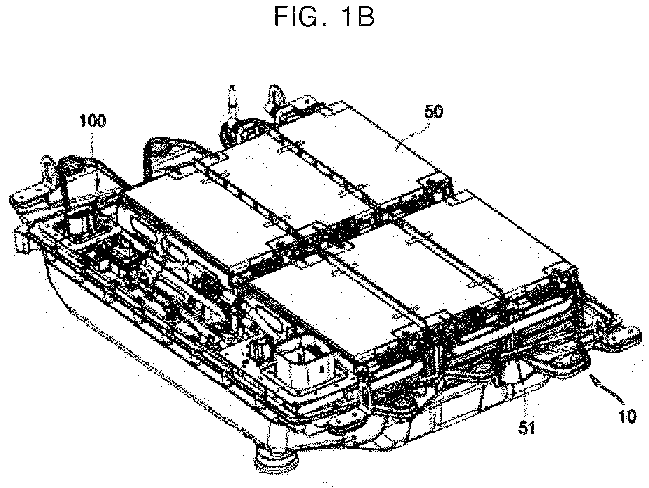

FIGS. 1A and 1B are views illustrating an example of a battery pack according to one embodiment of the present disclosure.

Referring to FIGS. 1A and 1B, a battery pack 100 may include a plurality of battery modules 50 and a housing 10 for accommodating the plurality of battery modules 50. For example, the housing 10 may include first and second housings 11 and 12 that are coupled to face each other with the plurality of battery modules 50 interposed therebetween. The plurality of battery modules 50 may be electrically connected to each other using a busbar 51, and the plurality of battery modules 50 may be electrically connected to each other in series/parallel or in a mixed series-parallel scheme to obtain required electrical output power.

The battery pack 100 includes one or more battery modules and a pack housing in which an accommodation space is formed to accommodate one or more battery modules 50.

The battery module 50 may include a plurality of battery cells and a module housing. The battery cells may be accommodated in the module housing in a stacked form. The battery cell may include a positive electrode lead and a negative electrode lead. Depending on a shape of a battery, a circular type, a prismatic type, or a pouch type battery cell may be used.

In the battery pack 100, instead of the battery module, one cell stack may constitute one module. The cell stack may be accommodated in an accommodation space of the pack housing or may be accommodated in an accommodation space partitioned by a frame, a partition, or the like.

The battery cell generates a large amount of heat during charging/discharging. The generated heat accumulates in the battery cell and accelerates the degradation of the battery cell. Accordingly, the battery pack further includes a cooling member to suppress the degradation of the battery cell. The cooling member may be provided at a lower portion of the accommodation space in which the battery cell is provided, but the present disclosure is not limited thereto. The cooling member may be provided at an upper portion or a side surface depending on the battery pack.

Each battery cell may experience abnormal operating conditions, also known as thermal runaway or a thermal event, in which an exhaust gas may be discharged to the outside of the battery cell. The battery pack or battery module may include an exhaust port for discharging the exhaust gas to prevent damage to the battery pack or battery module.

The battery pack may include a battery and a battery management system (BMS) for managing the battery. The BMS may include a detection device, a balancing device, and a control device. The battery module may include a plurality of cells connected to each other in series or parallel. The battery modules may be connected to each other in series or parallel.

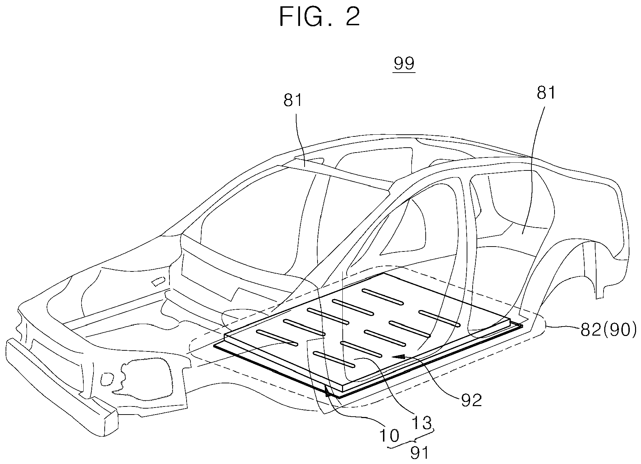

FIG. 2 is a view illustrating an example in which a battery pack is installed in a vehicle body according to one embodiment of the present disclosure.

In FIG. 2, a battery pack 91 may include a battery pack cover 13 that is a part of a vehicle underbody 92 and a pack frame 10 disposed below the vehicle underbody 92. The pack frame 10 and the battery pack cover 13 may be formed integrally with a vehicle bottom 82.

The vehicle underbody 92 separates the interior and exterior of the vehicle, and the pack frame 10 may be disposed on the exterior of a vehicle.

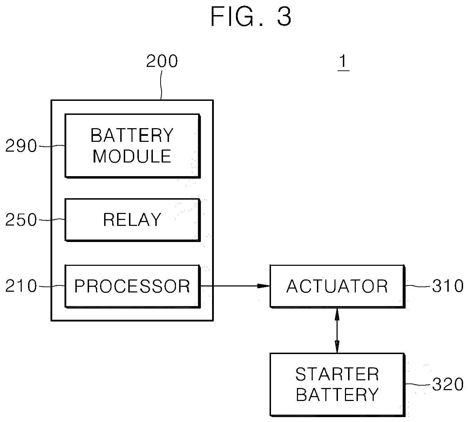

FIG. 3 briefly illustrates a configuration of a battery pack of an apparatus for protecting a battery pack and a vehicle according to one embodiment of the present disclosure.

Referring to FIG. 3, an apparatus 200 for protecting a battery pack according to one embodiment of the present disclosure includes a battery pack 100, an actuator 310, and a starter battery 320 which are provided in a vehicle 1.

The battery pack 100 includes a relay 250, a battery module 290, and a processor 210.

The relay 250 may output a discharge current of the battery module 290 to a load of the vehicle 1 or block the output.

The processor 210 monitors the state of the battery module 290 and may calculate a state of charge (SOC).

In addition, in response to the state of the battery module 290, the processor 210 controls a charge current applied to the battery module 290 or a discharge current applied from the battery module 290 to the load of the vehicle 1.

The processor 210 may turn on the relay 250 provided at an output terminal of the battery pack 100 to supply a discharge current of the battery module 290 to the load of the vehicle 1 and may turn the relay off to block the output of the battery module 290.

The processor 210 may monitor the state of the battery module 290, and when a failure is detected, it can control the relay 250 to block the output of the battery module 290.

In particular, when an abnormality of the battery module 290 is detected in a situation in which the vehicle is started, the processor 210 controls the relay 250 to block the output, whereby it may prevent the ignition of the vehicle from being turned on.

Meanwhile, during control of the relay 250, when a failure of the relay 250 is detected, the processor 210 cannot control the output of the battery module 290 through the relay 250 and thus may perform control such that an error is output.

In addition, the processor 210 may control the actuator 310 to prevent the ignition of the vehicle 1 from being turned on. The processor 210 may apply a signal to the actuator 310 to control the operation of the actuator 310 provided in the vehicle 1.

In a situation in which the output of the battery module 290 cannot be controlled due to a failure of the relay 250, the processor 210 controls the actuator 310 to prevent the ignition of the vehicle 1 from being turned on.

The actuator 310 is one of the devices provided in the vehicle 1 and operates according to a supplied current. For example, the actuator 310 may include a heater for a vehicle or a heat pump for cooling the vehicle.

The processor 210 operates the actuator 310 when the relay 250 fails. In this case, the actuator 310 may operate by receiving operating power from the starter battery 320.

The starter battery 320 is a 12V battery that supplies power when the vehicle is started.

The starter battery 320 is discharged after a certain time due to the operation of the actuator 310.

The processor 210 may control the start of the vehicle 1 by discharging the starter battery 320 through the actuator 310 before the ignition of the vehicle 1 is turned on.

The vehicle 1 may not be started due to the discharging of the starter battery 320.

Accordingly, according to the present disclosure, in a situation in which the vehicle is attempted to be started, when a failure of the battery pack 100 is detected, the ignition of the vehicle is prevented from being turned on, thereby preventing vehicle accidents.

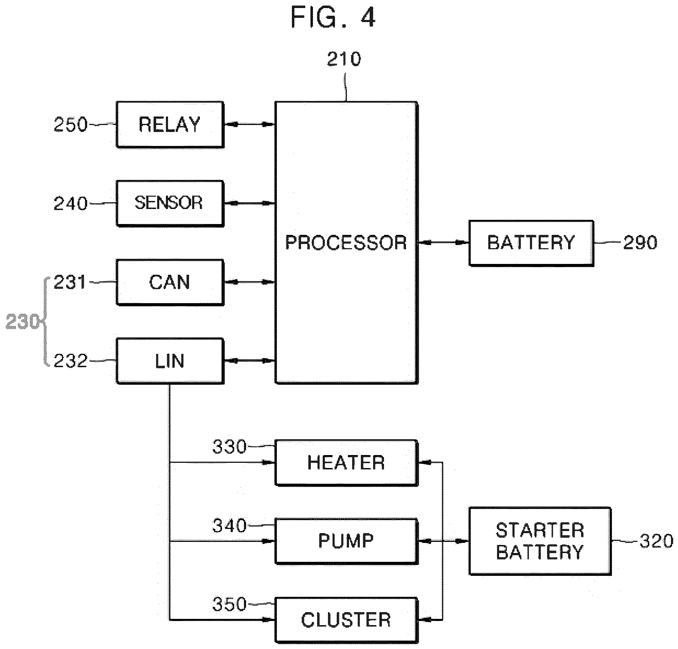

FIG. 4 briefly illustrates a configuration of an apparatus for protecting a battery pack according to one embodiment of the present disclosure.

As shown in FIG. 4, an apparatus 200 for protecting a battery pack according to one embodiment of the present disclosure may include a battery module 290, a relay 250, a sensor 240, a communication unit 230, and a processor 210.

In addition, the apparatus 200 for protecting a battery pack may include an actuator 310, a cluster (dashboard) 350, and a starter battery 320. The actuator 310 may include a heater 330 and a pump (heat pump) 340.

The sensor 240 may include at least one of a current sensor, a voltage sensor, and a temperature sensor.

The temperature sensor measures a temperature of the battery module 290 and provides a measurement result to the processor 210. The current sensor measures a charge current or a discharge current of the battery module 290 and provides a measurement result to the processor 210. The voltage sensor measures a voltage of the battery module 290 and provides a measurement result to the processor 210.

The communication unit 230 transmits or receives data between the processor 210, the battery module 290, the sensor 240, and the relay 250. In addition, the communication unit 230 may transmit or receive data between the processor 210, the heater 330, the pump 340, and the cluster 350.

The communication unit 230 may include a controller area network (CAN) communication module 231 including a driver for CAN communication and a local interconnect network (LIN) communication module 232 including a driver for LIN communication.

The LIN communication module 232 may transmit a control signal of the processor 210 to the heater 330 and the pump 340, which are actuators 310.

In addition, the LIN communication module 232 may transmit a control signal of the processor 210 to the cluster 350.

Although an example in which the LIN communication module 232 and the actuator 310 are connected is described, a control signal of the processor 210 may also be transmitted through the CAN communication module 231.

The relay 250 is provided at an output terminal of the battery pack 100 and operates according to a control command of the processor 210. The relay 250 is turned on to output a discharge current of the battery module 290 to a load of a vehicle 1 and allow a charge current from a charger (not shown) to be applied to the battery module 290. The relay 250 is turned off to block the charge current and discharge current.

As the relay 250, a mechanical contactor that is turned on or off by a magnetic force of a coil may be used. In addition, instead of the relay 250, a semiconductor switch such as a metal oxide semiconductor field effect transistor (MOSFET) may be used.

The processor 210 may monitor a state of the battery module 290 through the sensor 240 and may calculate an SOC. In addition, the processor 210 may detect a failure of the battery module 290.

When a temperature measured through the sensor 240 is higher than or equal to a set temperature and/or when an overcurrent or overvoltage is detected, the processor 210 may determine a failure of the battery module 290.

The processor 210 may control the relay 250 in response to a failure of the battery module 290. When the processor 210 determines that the battery module 290 has failed due to at least one of a high temperature, an overcurrent, and an overvoltage, the processor 210 applies a control command to the relay 250 to turn the relay 250 off.

When the relay 250 is turned off, the output of the battery module 290 may be blocked without being applied as the load of the vehicle 1.

When a starter key of the vehicle 1 is input, the processor 210 may determine whether the battery module 290 is operating normally before the vehicle is started.

As the processor 210, any one of a battery management system (BMS), a battery pack control module (BPCM), a central processing unit (CPU), an electronic control unit (ECU), and a micro controller unit (MCU) may be used.

When a failure of the battery module 290 is detected before the ignition of the vehicle is turned on, the processor 210 may control the relay 250 to block the output of the battery module 290. As the relay 250 is turned off, a discharge current of the battery module 290 is blocked without being supplied to the load of the vehicle 1.

In this case, the processor 210 may determine whether an operating state of the relay 250 is normal in response to a current measured through the sensor 240.

After the processor 210 controls the relay 250 to be turned off, when a discharge current of the battery module 290 is output, the processor 210 may determine that the relay 250 has failed.

The processor 210 cannot control the output of the battery module 290 when the relay 250 fails and thus may control the actuator 310 to turn the ignition off before the ignition of the vehicle 1 is turned on.

The processor 210 may transmit a control signal to the actuator 310 through the LIN communication module 232.

The processor 210 transmits a control signal to at least one of the heater 330 and the pump 340, which are actuators 310, that is operated by the starter battery 320. In this case, as the actuator 310, any device may be applied as long as the device is operated by power supplied from the starter battery 320. However, it is preferable that a device that consumes a large amount of power for a short time be used as the actuator 310.

At least one of the heater 330 and the pump 340 may start to operate according to the control signal. The heater 330 and pump 340 may start to operate based on power supplied from the starter battery 320 and control an internal temperature of the vehicle 1.

In this case, the starter battery 320 may be a 12V battery and may be discharged within a certain time due to the operations of the heater 330 and the pump 340.

Accordingly, when a failure of the battery pack 100 is detected in a starting situation, the processor 210 may control the relay 250 to block the output of the battery module 290. When the relay 250 fails, the processor 210 may control the actuator 310 to discharge the starter battery 320, thereby allowing the vehicle to maintain an off-state without the ignition being turned on.

When the battery pack 100 fails, since the vehicle 1 cannot drive normally, the processor 210 can control the start of the vehicle 1 to prevent accidents.

Meanwhile, the processor 210 may generate failure information and output an error in response to a failure of the battery module 290 and a failure of the relay 250. The processor 210 may control any one of the CAN communication module 231 and the LIN communication module 232 of the communication unit 230 to transmit the failure information to the cluster 350.

The processor 210 may control the cluster 350 to output the failure information through the cluster 350. In addition, the processor 210 may transmit the failure information to a main processor (not shown) of the vehicle through the communication unit 230. In this case, the main processor may output the failure information through the cluster 350 based on the failure information.

The cluster 350 may output an error according to the failure information in the form of at least one of a warning light, a warning message, and a warning sound. The cluster 350 may output an error regarding either the battery pack 100 or the relay 250.

The processor 210 allows error output through the cluster 350 to be maintained until a separate reset signal is input.

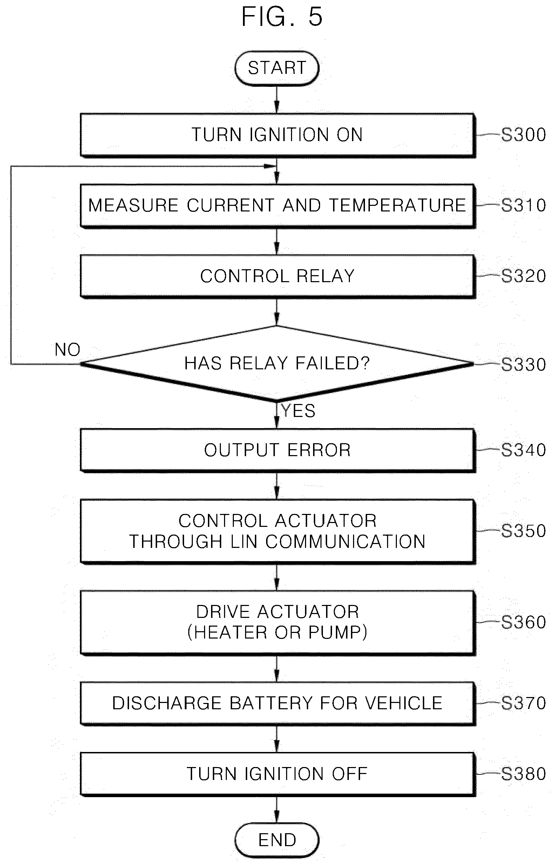

FIG. 5 illustrates a method of protecting a battery pack according to one embodiment of the present disclosure.

Referring to FIG. 5, when a start signal is input (S300), a processor 210 measures a temperature, a current, and a voltage of a battery module 290 through a sensor 240 (S310).

The processor 210 may determine a failure of the battery module 290 based on the measurement data of the sensor 240.

The processor 210 may determine that the battery module 290 has failed for at least one of a case in which the temperature of the battery module 290 is higher than or equal to a set temperature, a case in which the current of the battery module 290 is an overcurrent, and/or a case in which an overvoltage is measured.

When it is determined that the battery module 290 has failed, the processor 210 controls a relay 250 to be turned off (S320).

The processor 210 controls the relay 250 to be turned off and then measures a current through the sensor 240 to check an operating state of the relay 250.

When the relay has failed (S330), the processor 210 generates failure information and outputs an error (S340).

When a discharge current of the battery module 290 is output through the relay 250, the processor 210 may determine that the relay 250 has failed.

The processor 210 controls any one of a CAN communication module 231 and a LIN communication module 232 of a communication unit 230 to transmit the failure information to a cluster (dashboard) 350. The processor 210 may perform control such that the failure information is output through the cluster 350.

The cluster 350 may output an error regarding a failure of the battery module 290 and a failure of the relay 250.

In addition, the processor 210 may transmit a control signal to at least one of a heater 330 and a pump (heat pump) 340, which are actuators 310, through the LIN communication module 232 (S350).

The processor 210 controls at least one of the heater 330 and the pump (heat pump) 340 to operate through the control signal.

In this case, the processor 210 may transmit a control signal according to turn-on/off to the actuator 310 to control the actuator 310 using the LIN communication module 232, which has a simple protocol configuration.

The actuator 310 may start to operate according to the received control signal (S360). The actuator 310 operates by receiving operating power from a starter battery 320 connected thereto.

The starter battery 320 may be discharged due to the operation of at least one of the heater 330 and the pump 340 (S370).

Accordingly, when a failure is detected in the battery pack 100 in a starting situation, before the ignition of a vehicle is turned on, the starter battery 320 is discharged to block operating power, thereby controlling the vehicle 1 to maintain an ignition-off state (S380).

Therefore, according to an apparatus and method of protecting a battery pack of the present disclosure, in a situation in which a vehicle is started, a failure of a battery module and a relay is detected to block the output of a battery module 290 and allow occupants to recognize the failure. In addition, according to an apparatus and method of protecting a battery pack of the present disclosure, in a situation in which a vehicle is started, when a failure of a relay is detected and thus the output of a battery module cannot be controlled, an actuator operates to discharge a starter battery. Thus, it is possible to effectively control the vehicle such that the ignition is not turned on, thereby preventing accidents due to a failure of the battery pack.

According to the present disclosure, in response to a failure of a battery pack and a relay, a starter battery can be discharged to stably turn the ignition of a vehicle off, and occupants and the vehicle can be protected from accidents.

According to the present disclosure, failure information may be output through a cluster of a vehicle to allow occupants to recognize an abnormality of a battery pack, thereby allowing a quick response to a failure.

However, the effects that can be achieved through the present disclosure are not limited to the above-described effects, and other technical effects that are not described herein will be clearly understood by those skilled in the art from the following disclosure.

Although the present disclosure has been described with limited embodiments and drawings, the present disclosure is not limited to thereto, and instead, it will be appreciated by those skilled in the art that various modifications and changes may be made to these embodiments without departing from the principles of the present disclosure, the scope of which is defined by the claims and their equivalents.

Implementations described herein may be implemented in, for example, a method or process, an apparatus, a software program, a data stream, or a signal. Although discussed only in the context of a single form of implementation (e.g., discussed only as a method), implementations of the discussed features may also be implemented in other forms (for example, an apparatus or a program). The apparatus may be implemented in suitable hardware, software, firmware, and the like. A method may be implemented in an apparatus such as a processor, which is generally a computer, a microprocessor, an integrated circuit, a processing device including a programmable logic device, or the like. Processors also include communication devices such as a computer, a cell phone, a portable/personal digital assistant ("PDA"), and other devices that facilitate communication of information between end-users.

Here, the processor may be implemented as a central processing unit (CPU) or a system on chip (SoC), may drive an operating system or application to control a plurality of hardware or software components connected to the processor, and may process various pieces of data and perform calculations. The processor may be configured to execute at least one instruction stored in a memory (not shown) and store execution result data in the memory.

The present disclosure has been described with reference to embodiments shown in the drawings, but this is merely illustrative, and those skilled in the art will understand that various modifications and other equivalent embodiments are possible therefrom. Therefore, the technical protection scope of the disclosure should be defined by the appended claims.

## Claims

1. An apparatus for protecting a battery pack, the apparatus comprising:
a battery module;
a relay configured to allow an output of the battery module to be applied as a load of a vehicle or block the output of the battery module;
an actuator operated by power supplied from a starter battery; and
a processor configured to, when a start signal is input, monitor the battery module and detect a failure of the relay, and when the relay fails, control the actuator to operate to discharge the starter battery and block a start of the vehicle.

2. The apparatus of claim 1, wherein, when the start signal is input, the processor monitors the battery module, detects a failure of the battery module, and controls the relay in response to the failure of the battery module to block the output of the battery module.

3. The apparatus of claim 1 or claim 2, wherein the processor detects a failure of the battery module based on at least one of a temperature, a current, and a voltage of the battery module measured by a sensor, controls the relay to be turned off when the battery module fails, and then determines the failure of the relay based on the current of the battery module.

4. The apparatus of any one of the preceding claims, wherein, when a failure of the battery module and the relay is detected, the processor allows a vehicle to maintain an ignition-off state by discharging the starter battery before an ignition of the vehicle is turned on by the start signal.

5. The apparatus of any one of the preceding claims, wherein the processor transmits a control signal to the actuator through a local interconnect network (LIN) communication module to cause the actuator to operate.

6. The apparatus of any one of the preceding claims, wherein the actuator includes at least one of a heater and a pump, which are connected to the starter battery, to operate.

7. A method of protecting a battery pack, the method comprising:
when a start signal is input, monitoring, by a processor, a battery module and detecting a failure of a relay;
when the relay fails, applying, by the processor, a control signal to an actuator of a vehicle;
operating the actuator using power supplied from a starter battery; and
discharging the starter battery and turning an ignition of the vehicle off.

8. The method of claim 7, wherein the detecting of the failure includes, when the start signal is input, monitoring, by the processor, the battery module and detecting a failure of the battery module, and when the battery module fails, controlling the relay to block an output of the battery module and detecting the failure of the relay.

9. The method of claim 8, wherein, in the detecting of the failure, the processor detects a failure of the battery module based on at least one of a temperature, a current, and a voltage of the battery module measured by a sensor.

10. The method of claim 8 or claim 9, wherein, in the detecting of the failure, the processor controls the relay and then determines the failure of the relay based on the current of the battery module.

11. The method of any one of claims 7 to 10, wherein, in the applying of the control signal, the processor transmits the control signal to the actuator through a local interconnect network (LIN) communication module to cause the actuator to operate.

12. The method of any one of claims 7 to 11, wherein, in the operating of the actuator, the actuator operates by power supplied from the starter battery to discharge the starter battery.

13. The method of any one of claims 7 to 12, wherein, in the operating of the actuator, the actuator includes at least one of a heater and a pump connected to the starter battery.

14. The method of any one of claims 7 to 13, wherein, in the turning of the ignition of the vehicle off, the processor causes the vehicle to maintain an ignition-off state by discharging the starter battery before the ignition of the vehicle is turned on by the start signal.

15. The method of any one of claims 7 to 14, wherein the method is carried out by the apparatus of any one of claims 1 to 6.
